(19) Europäisches Patentamt
European Patent Office
Office européen des brevets

(11) Publication number: **0 161 660 B1**

(12) # EUROPEAN PATENT SPECIFICATION

(45) Date of publication of patent specification: **09.10.91** (51) Int. Cl.[5]: **G03F 7/16**

(21) Application number: **85105876.8**

(22) Date of filing: **13.05.85**

The file contains technical information submitted after the application was filed and not included in this specification

(54) **Pattern forming method and composition for pattern formation to be used therefor.**

(30) Priority: **14.05.84 JP 94603/84**
**19.11.84 JP 242281/84**
**17.12.84 JP 264450/84**

(43) Date of publication of application:
**21.11.85 Bulletin 85/47**

(45) Publication of the grant of the patent:
**09.10.91 Bulletin 91/41**

(84) Designated Contracting States:
**DE FR GB**

(56) References cited:

| | |
|---|---|
| DE-A- 3 144 656 | DE-A- 3 144 657 |
| FR-A- 2 025 640 | FR-A- 2 077 584 |
| FR-A- 2 209 207 | GB-A- 2 005 855 |
| GB-A- 2 111 705 | JP-A-52 130 286 |
| US-A- 3 836 366 | US-A- 3 899 332 |

**DERWENT JAPANESE PATENTS REPORT, vol. 9, no. 21, 7th July 1971, Section G, page 6; & JP-A-71 18 924 (RIOCH CO. LTD) 27-05-1971**

(73) Proprietor: **KABUSHIKI KAISHA TOSHIBA**
**72, Horikawa-cho Saiwai-ku**
**Kawasaki-shi Kanagawa-ken 210(JP)**

(72) Inventor: **Ikari, Kunihiro**
**Kabushiki Kaisha Toshiba 72,Horikawa-cho Saiwai-Ku**
**Kawasaki-shi Kanagawa-ken(JP)**
Inventor: **Niki, Hirokazu**
**Kabushiki Kaisha Toshiba 72,Horikawa-cho Saiwai-Ku**
**Kawasaki-shi Kanagawa-ken(JP)**
Inventor: **Nakase, Makoto**
**Kabushiki Kaisha Toshiba 72,Horikawa-cho Saiwai-Ku**
**Kawasaki-shi Kanagawa-ken(JP)**
Inventor: **Shinozaki, Toshiaki**
**Kabushiki Kaisha Toshiba 72,Horikawa-cho Saiwai-Ku**
**Kawasaki-shi Kanagawa-ken(JP)**

(74) Representative: **Eitle, Werner, Dipl.-Ing. et al**
**Hoffmann, Eitle & Partner Patentanwälte Arabellastrasse 4**
**W-8000 München 81(DE)**

EP 0 161 660 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

PATENTS ABSTRACTS OF JAPAN, vol. 6, no. 248 (P-160)[1126], 7th December 1982; & JP-A-57 146 247 (TOKYO SHIBAURA DENKI K.K.) 09-09-1982; & US-A-4 501 806 (filed: 01-09-1982; published 26-02-1985)

IBM TECHNICAL DISCLOSURE BULLETIN, vol. 8, no. 7, December 1965, page 980, New York, US; H.J. ZWEIG: "Nonlinear filter"

PATENTS ABSTRACTS OF JAPAN, vol. 7, no. 105 (P-195)[1250], 7th May 1983; & JP-A-58 28 739 (NIPPON DENKI K.K.) 19-02-1983

IEEE ELECTRON DEVICE LETTERS, vol. EDL-4, no. 1, January 1983, pages 14-16, IEEE, New York, US; B.F. GRIFFING et al: "Contrast enhanced photolithography"

## Description

This invention relates to a pattern forming method suitable for minute working and a composition for pattern formation to be used therefor, more particularly to a method for pattern formation for obtaining a minute pattern by a simple method and yet with good dimensional precision and stably and also a composition for pattern formation to be used therefor.

In production of integrated circuits, there exists a step of forming a minute pattern on a semiconductor wafer. This step is generally constituted of the operations as described below. First, a substrate such as wafer is coated with a resist solution and dried to form a resist film thereon. Thereafter, with this resist film brought into contact with a desired pattern, a light to which the resist film is sensitive is irradiated thereon to effect pattern exposure. Next, the resist film is developed to form a desired minute pattern.

The degree of integration in integrated circuits has been made higher in density at a rate of about 4-fold within every 2 to 3 years, and correspondingly the dimensions of the patterns required for minute working of an element are becoming increasingly minute, and also severe control is demanded for dimensional precision. In response to these demands, developments of pattern forming techniques which can form minute patterns and yet can maintain dimensional precision in spite of changes in steps are now under progress with vigorous efforts, not only in exposure devices, but in both aspects including the resist material to be used therefor.

Whereas, as one of the factors which limit the resolution necessary for formation of a minute pattern, there is the diffraction phenomenon based on the wave characteristic of light (corpuscular beam). The diffraction theory indicates that the resolution of the exposure system will be increased as the wavelength of the light (corpuscular beam) is shorter. For this reason, developments of the exposure techniques employing far UV-ray (wavelength 200 - 300 nm), X-ray and electron beam are progressing. However, there are involved the problems that these techniques require an expensive device and also that it is deficient in bulk productivity. Accordningly, under such the present situation only the electron beam exposure technique is used for mask pattern formation for wafer working among these techniques. On the other hand, if the UV-ray exposure technique (wavelength 300 - 450 nm) which has conventionally been used in the prior art is applicable, the prior art techniques are available as such to be very advantageous in bulk productivity and also in aspect of economy. Practically, there remains sufficient room for improving the UV-ray exposure technique so as to be applicable for submicron minute working of ultra-LSI. The elemental techniques required for improvement of UV-ray exposure technique as viewed from the standpoint of pattern miniaturization are as follows:

(1) to shorten wavelength of the light to be used for image formation system;
(2) to employ an optical system with a large numerical aperture;
(3) to enlarge $\gamma$-value (contrast) of the resist;
(4) to make thinner the resist film; and
(5) to improve optical contrast for the resist by provision of a bleaching thin film.

The techniques (1) and (2) concern primarily improvement of optical system, and improvement of resolution can be expected also from the optical theory, but no sufficient dose can be obtained at a short wavelength due to decreased transmittance of the lens. Further, enlargement of a numerical aperture will pose a problem such that the focal depth becomes shallower to become weak against uneven steppage difference on the wafer surface. On the other hand, (3), (4) and (5) concern improvement of the resist itself.

If the $\gamma$-value is increased, in addition to increase in resolution, a sharp pattern will be obtained, and there is also the advantage of no film loss during development. Approaches to increase the $\gamma$-value, which depend directly on the chemical structure of the resist material, cannot be described indiscriminately, but the proposed methods include (1) the method in which the molecular distribution of the polymeric material is narrowed and (2) the method in which a material which is faded by photolysis through absorption of the light to which the resist is sensitive is incorporated in the resist material (Japanese Provisional Patent Publication No. 130286/1977). However, the method (1), which is generally applied for a cross-linked type resist, is limited to the attainable $\gamma$-value, and also the approach (2), which can give some effect, is limited in the amount of the fading material added, because the resist function is affected thereby. In view of such situations, improvement of $\gamma$-value is also limited.

If the film thickness of the resist is made thinner, unfocused image based on the scattering phenomenon of light will be reduced to result in improvement of resolution. But, if the film is made too thin, there will ensue a problem such as formation of pinholes during film formation.

On the other hand, one may consider that resolution can be improved without adverse effect on the resist function by provision of a photosensitive thin film containing a photobleachable material on the resist film. B.F. Griffing et al. proposed to provide a photosensitive layer containing a bleaching dye on a

positivetype resist film [IEEE, ELECTRON DEVICE LETTERS Vol. EDL-4, (1) 14 (1983)]. Also, there has been proposed a method to improve substantially the optical contrast by providing a photobleachable positive-type resist film on a negative-type resist film (Japanese Provisional Patent Publications No. 64971/1979 and No. 70761/1979).

Whereas, the specific feature of these methods resides in apparent improvement in optical contrast relative to the resist by alternating the illumination distribution of the pattern to pass through the photobleachable film. In other words, the faded quantity is smaller at a shadow portion where the dose is relatively smaller, while contrariwise it is greater at a highlight portion. Accordingly, as compared with the shadow portion, the transmitted light at the highlight portion is relatively intensified, which means that apparent optical contrast has been improved relative to the resist film.

For practicing effectively the improved optical contrast method, the photobleachable substance is required to satisfy the following conditions:

(1) to absorb sufficiently the light to which the resist is exposed and fade sufficiently;

(2) the fading speed should be approximate to the photosensitive speed of the resist; and

(3) after fading, it should be faded into a sufficiently transparent material.

When a dye such as Rhodamine 6G is used as the photobleachable material, the fading speed is slow and therefore it is practically difficult to apply a dye. Japanese Provisional Patent Publications No. 64971/1979 and No. 70761/1979 disclose substantial improvement of optical contrast by use of a positive-type resist itself as a photobleachable material. However, in these methods, there is involved the problem that the coefficient of light absorption of the positive-type resist is small, whereby the light of the shadow portion cannot sufficiently be shielded. If the film thickness of the resist is made thick, there is involved the problem, although the light shielding ability can be improved, that the image will become unfocused to worsen contrariwise the resolution.

Also, Japanese Provisional Patent Publication No. 104642/1984 discloses use of arylnitrone as the color fading substance. When this substance is used, due to large coefficient of light absorption, the photosensitive film can be made thin to result in improvement of resolution. However, arylnitrone is chemically unstable and therefore suceptible to decomposion by water or heat, thus posing a problem in difficult control in the manufacturing steps. Accordingly, there is also involved the problem that it is not possible to produce minute patterns stably.

GB-A-2111705 discloses a pre-senitised lithographic printing plate having a layered structure including a base, a layer containing a light-sensitive diazo resin, and a second layer comprising a non-light-sensitive polymer containing a diazonium salt which absorbs light of the same wavelength to which the diazo resin in the first layer is sensitive.

DE-A-3144657 discloses a light-sensitive mass containing an o-naphthaquinone diazide compound, a resin, an organic dye capable of forming a salt with an acid, an aromatic diazonium salt with various fluoride or chloride compounds, and an acid or an acid anhydride.

Derwent Japanese Patents Reports, Vol. 9, No. 21, section G, page 6 discloses the use of diazonium salts in a diazo type photosensitive mimeographic printing paper.

US-A-3836366 discloses a planographic printing plate incorporating various diazonium salts.

FR-A-2209207 discloses a process for manufacturing screens for cathode ray tubes in which a layer of sharply defined hardened portions of polyvinyl alcohol are provided by a method comprising irradiating a light-sensitive substance capable of absorbing light with a wavelength of around 365 microns and which on exposure to said light decomposes into a compound transparent to said light, this compound being spread on a photosensitive layer of polyvinyl alcohol and a light-sensitive hexavalent chromium compound. The reference further describes insertion of a layer of an inert water-soluble material between the light-hardenable layer of polyvinyl alcohol and the layer containing the light-absorbing substances.

FR-A-2077584 discloses a lithographic plate which includes a support and a light-sensitive layer including two light-sensitive compounds. One of these light-sensitive compounds changes colour when exposed to light.

US-A-3899332 discloses a process for developing a printing plate comprising a substrate coated with a diazo resin photosensitizer and a photosensitive diazo-borofluoride salt.

FR-A-2025640 discloses a light-sensitive reproduction assembly comprising a support, a first layer containing a light-sensitive substance such as a quinone diazide, and a second layer containing a chemical system whose absorption of light, to which the photosensitive substance in the first layer is sensitive, increases on exposure to that light.

An object of the present invention is to provide a method for pattern formation which has cancelled the problems as described above, is suitable for minute working even by use of visible light and can give minute patterns with good dimensional precision and stability by a simple method, and a composition for

pattern formation to be used therefor.

The present inventors have studied intensively about the materials of the photosensitive film to be formed on the resist film in order to accomplish the above object, and consequently found that the photosensitive film containing photosensitive diazonium salts as described hereinafter has the advantages of having sufficiently greater light shielding ability against UV-rays with wavelengths of 300 - 450 nm as compared with the color fading dye or positive-type resist itself used in the prior art, having a light fading speed approximate to the sensitizing speed of the resist and giving a substantially transparent film after bleaching, to develop the pattern forming method and a composition to be used therefor of the present invention.

More specifically, the pattern forming method of the present invention comprises the steps of providing a resist film on a substrate; providing a photosensitive film containing a photosensitive diazonium salt on the resist film; and then subjecting the resultant composite to pattern exposure by use of a light to which both of the resist film and the photosensitive diazonium salt are sensitive.

The composition to be used in the pattern forming method of the present invention comprises a photosensitive diazonium salt, a resin binder and a solvent.

In the composition for pattern formation of the present invention, there may further be contained organic acids.

Fig. 1 through Fig. 8 are graphs for explanation of the effects of the present invention, Fig. 1 and Fig. 3 being graphs showing dependency of the line width after pattern developing on exposure time; Fig. 2 and Fig. 4 being graphs showing dependency of variance in dimensional precision on line width; and Fig. 5 through Fig. 8 are graphs showing relationship between the deviation from the mask dimension of the pattern formed in Example 20 and the exposure time; and all the marks

—●—

representing the results of the invention and all the marks

—○—

those of Comparative example, respectively.

The minute pattern forming method of the present invention is described in detail below.

In the method of the present invention, first a resist film is formed on a semiconductor wafer. The resist used in not particularly limited and may include, for example, the so-called positive-type resist comprising an esterified product of naphthoquinonediazidesulfonic acid and cresol novolac resin, the so-called rubbery negative-type resist comprising a bisazide compound formulated in a cyclized polyisoprene, a negative-type resist comprising an azide compound formulated in polyvinylphenol resin or phenol-novolac resin, various resist materials comprising bichromates formulated in a water-soluble resin, water-soluble resist comprising a bisazide compound formulated in polyvinylpyrrolidone and others.

Then, on the resist film is applied the composition for pattern formation of the present invention, namely a photosensitive solution comprising a photosensitive diazonium salt as described below and a resin binder dissolved in a suitable solvent by, for example, a spinner, followed by drying, to provide a photosensitive film thereon. Next, by use of light acting on both the resist and the diazonium salt, pattern exposure is effected. Next, the diazo photosensitive layer is removed, followed subsequently by developing the resist layer, to give a pattern.

In the pattern forming method and the composition to be used therefor, the diazonium salt compound is selected from the following formulae (I) - (VI).

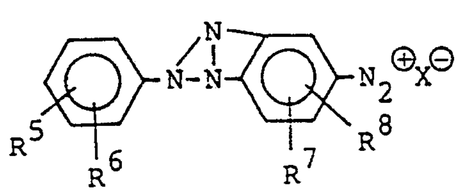

(I)

wherein $R^5$, $R^6$, $R^7$ and $R^8$ may be either identical or different and each represent a hydrogen atom, a

halogen atom, an amino group, a sulfo group, a carboxyl group, an alkyl group, an alkoxy group, a dialkylamino group, an alkylmercapto group or an acyl group each having 1 to 6 carbon atoms, an aryl group or an aralkyl group each having 6 to 12 carbon atoms; and X represents a halogen ion, a sulfate ion or an anion consisting of a halide of either boron, phosphorus, zinc, arsenic, aluminum, iron or antimony.

In $R^5$, $R^6$, $R^7$, $R^8$ of the above formula, when they are alkyl groups, alkoxy groups, dialkylamino groups, alkylmercapto groups or acyl groups, those having carbon atoms greater than 6 are not preferable, because solubility and film forming property will lowered. Also, in the case of aryl groups or aralkyl groups, those having carbon atoms greater than 12 are not preferable for the same reason.

Preferable examples of the anion: $X^{\ominus}$ may be $BF_4^{\ominus}$, $PF_6^{\ominus}$, $HSO_4^{\ominus}$, $1/2SO_4^{2\ominus}$, $ZnCl_2 \cdot Cl^{\ominus}$.

Such diazonium salts represented by the formula (I ) may be, for example, 2-(4'-methoxyphenyl)-6-chloro-1,3-benzotriazole-5-diazonium salts, 2-(4'-methoxyphenyl)-6-methyl-1,3-benzotriazole-5-diazonium salts, 2-naphthyl-1,3-benzotriazole-5-diazonium salts, 2-(3'-N,N-dimethylaminonaphthyl)-1,3-benzotriazole-5-diazonium salts and the like.

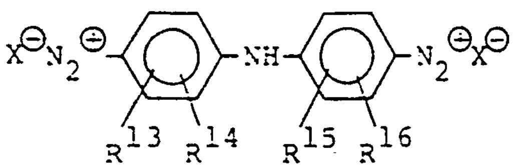

(II)

$R^{13}$, $R^{14}$, $R^{15}$ ad $R^{16}$ each represent a hydrogen atom, a halogen atom, an alkyl group, an alkenyl group, an alkoxy group, an aryl group, an aralkyl group, an amino group, a dialkylamino group, an alkylmercapto group, an acyl group, a sulfo group or a carboxyl group; and X represents an anion capable of forming a diazonium salt.

In the above formula (II), X is not specifically limited, but may include, for example, a halogen ion, a sulfate ion or an anion consiting of a halogen compound of boron, phosphorus, zinc, arsenic, aluminum, iron and antimony.

$R^{13}$, $R^{14}$, $R^{15}$ and $R^{16}$ each represent a hydrogen atom, a halogen atom, an alkyl, an alkenyl, an alkoxy, an aryl, an aralkyl, an amino, a dialkylamino, an alkylmercapto, an acyl, a sulfo or a carboxyl.

Typical examples represented by the formula (II) may include N,N-bis-(4-diazophenyl)amine, N,N-bis-(3-methoxy-4-diazophenyl)amine, N,N-bis-(3-N,N'-dimethylamine-4-diazophenyl)amine, N,N-bis-(2,5-dimethoxy-4-diazophenyl)amine, and the like.

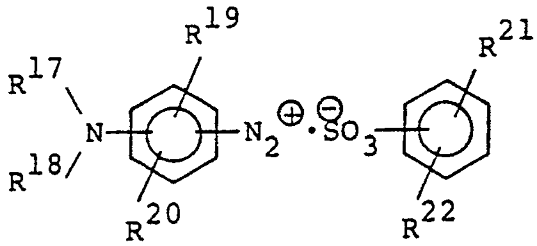

(III)

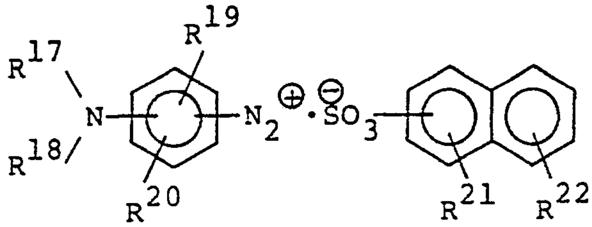

(IV)

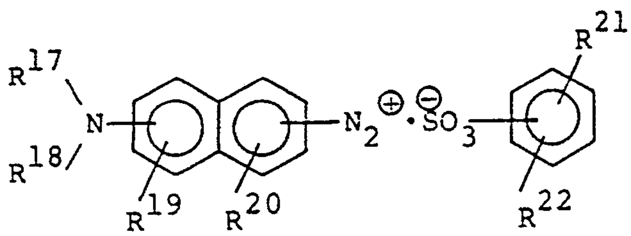

(V)

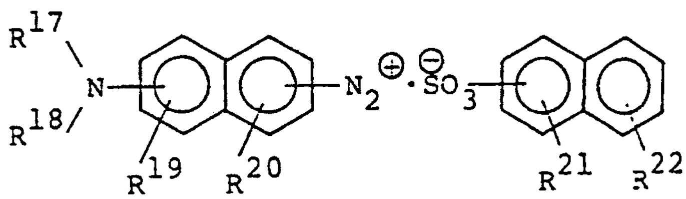

(VI)

wherein $R^{17}$ and $R^{18}$ each represent a hydrogen atom, an alkyl group having 1 to 6 carbon atoms, a phenyl group, or $R^{17}$ and $R^{18}$ taken together may be cyclized through a carbon, oxygen or nitrogen atom; $R^{19}$ and $R^{20}$ each represent a hydrogen atom, a halogen atom, an alkyl group, an alkoxy group or an alkenyl group each having 1 to 6 carbon atoms; $R^{21}$ and $R^{22}$ each represent a hydrogen atom, a hydroxyl group, a carboxyl group, a sulfo group, an alkyl group or an alkoxy group each having 1 to 6 carbon atoms, an amino group, a nitro group or a benzoyl group.

In $R^{17}$ to $R^{22}$ in the above formulae (III) - (VI), when they are alkyl groups, alkoxy groups or alkenyl groups, those having carbon atoms greater than 6 are not preferable, because solubility and film forming property of the photosensitive diazonium salt will be lowered.

Examples in which $R^{17}$ and $R^{18}$ are cyclized through carbon, oxygen or nitrogen atom may include, for example, an ethyleneimino group, a trimethyleneimino group, a pyrrolidino group, a piperidino group, a morpholino group, a cycloheptylamino group, and the like.

The photosensitive dizaonium salts represented by the above formulae (III) - (VI) may be exemplified by 3,4-dimethyl-6-pyrrolidylbenzenediazonium-p-toluenesulfonic acid salts, 3-methoxy-4-pyrrolidylbenzenediazoniumsulfosalicylic acid salts, 2-chloro-6-morpholinobenzenediazonium-p-toluenesulfonic acid salts, 2,5-dibutoxy-4-morpholinobenzenediazoniumnaphthalenesulfonic acid, 4-N,N-dibutylaminobenzenediazonium-p-phenolsulfonic acid, 4-N-phenylamino-naphthalenediazoniumnaphthalenesulfonic acid, 4-N,N-dimethylamino-naphthalenediazoniumsulfosalicylic acid salts, 4-N,N-dibutylaminonaphthalenediazonium-p-toluenesulfonic acid salts and the like.

The reason why the photosensitive diazonium salts represented by the formulae (I) - (VI) are excellently

effective in the method of the present invention is in the first place that the absorption band of these diazonium salts exists near 350 - 450 nm. This means that the g-line (wavelength 436 nm), h-line (wavelength 405 nm) and i-line (wavelength 365 nm) of the light source (mercury lamp) used presently in pattern exposure of an integrated circuit can very effectively be shielded.

Practically, of the diazonium salts used in the field of copying in general, particularly in photosensitive material for microflush or diazo photosensitive paper for copying, even those having absorption band at the longest wavelength region are limited in the absorption peak wavelength to around 405 nm, whereby the light shielding ability against the above g-line is not sufficient. By having a large amount of diazonium salts dissolved in the resin binder, its shielding ability can be increased, but when the dissolving limit is surpassed, the diazonium salt will be crystallized out to give no uniform transparent film.

Accordingly, by use of at least one photosensitive diazonium salts of the formulae (I) - (VI), the above problems can be cancelled, because a wavelength of the absorption peak of these salts coincide with the vicinity of g-line, h-line, i-line or the like.

In the present invention, by further adding 0.5 to 5 moles of sulfonic acid or its derivatives, or phenol, naphthol or their derivatives represented by the following formulae (X) - (XIII) per mole of said diazonium salt in the diazo photosensitive solution, the compatibility of the diazonium salt with the resin binder can be improved.

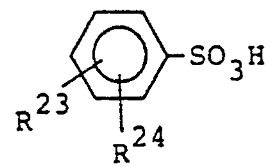

(X)

wherein $R^{23}$ and $R^{24}$ may be either identical or different and each represent a hydrogen atom, a halogen atom, a hydroxyl group, a carboxyl group, an alkyl group.

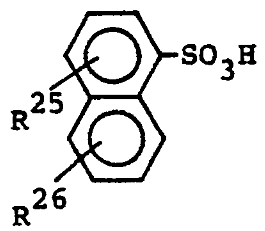

(XI)

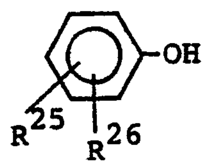

(XII)

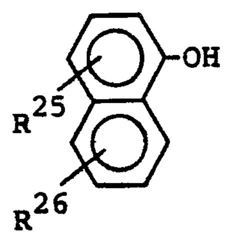

(XIII)

wherein $R^{25}$ and $R^{26}$ may be either identical or different and each represent a hydrogen atom, a halogen atom, a hyroxyl group, a carboxyl group, a sulfo group, an alkyl group having 1 to 5 carbon atoms, an amino group, a nitro group.

The benzenesulfonic acid or its derivatives represented by the formula (X) used in the present invention may include, for example, benzenesulfonic acid, p-toluenesulfonic acid, p-ethylbenzenesulfonic acid, p-hydroxybenzenesulfonic acid, cumenesulfonic acid, dodecylbenzenesulfonic acid and sulfosalicylic acid.

In the above formulae (XI) and (XII), when $R^{25}$ and $R^{26}$ are alkyl groups, they should preferably have 1 to 5 carbon atoms. If the carbon atoms are greater than 5, the solubility of the photosensitive diazonium salt and the film forming property of the photosensitive film will undesirably be lowered.

The naphthalenesulfonic acid derivative represented by the formula (XI) may include, for example, naphthalenesulfonic acid, 1,5-naphthalenedisulfonic acid, 1-naphthol-8-sulfonic acid, 1-naphthol-3,6-disulfonic acid, 1-naphthylamine-4-sulfonic acid and the like.

As the phenol derivative represented by the formula (XII), there may be mentioned, for example, phenol, 4-methylphenol, 4-ethylphenol, 2,6-dimethylphenol, p-tert-butylphenol, phenol-4-sulfonic acid, p-chlorophenol, resorcin, p-aminophenol, salicylic acid, sulfosalicylic acid and the like.

Further, as the naphthol derivative represented by the formula (XIII), there may be mentioned, for example, 1-naphthol, 1,2-naphthalenediol, 1-naphthol-4-carboxylic acid, 2,4-dichloro-1-naphthol, 6-amino-1-naphthol-3-sulfonic acid and the like.

The amount of the compound represented by the formula (X) added may be preferably at a ratio of 0.5 to 5.0 moles, more preferably 0.7 to 1.5 moles per mole of the diazonium salt.

Further, these compounds of the formula (XI), (XII) or (XIII) may be added at a ratio preferably of 0.5 to 5.0 moles, more preferably 0.5 to 2.0 moles, per mole of the diazonium salt. If the amount of these compounds to be added is less than 0.5 mole, the above effect is insufficient, while an amount in excess of 5.0 moles will lower film forming property and resolution of the photosensitive film.

Meanwhile, in the above pattern forming step, even when no sulfonic acid derivative or phenol derivative represented by the above formulae is added in the diazo photosensitive solution, the effect of "having sufficiently greater light shielding ability against UV-rays, having a bleaching speed matching to the sensitizing speed of the resist and giving a substantially transparent film after bleaching" can be obtained. However, by adding a sulfonic acid derivative, phenol derivative or naphthol derivative into the diazo photosensitive solution according to the present invention, the solubility of the diazonium salt under photosensitive solution state and the solubility of under the photosensitive film state (solubility with resin binder) have been found to be dramatically improved. Improvement of the solubility of the diazonium salt under the photosensitive film state means that a large amount of the diazonium salt can be dissolved per unit weight of resin binder, with the result that the UV-ray shielding ability of the diazo photosensitive film can dramatically be improved. According to the present invention, in addition to the above effects, additional effects of "improvement in resolution with little unfocused image, due to the diazo photosensitive member which can be made thinner", and "enlarged scope of applicable diazonium salts" were found to be obtained.

The present inventors have investigated about solubility of various diazonium salts with resin binders. As the result, it was found that the compatibility could not be stated to be so great. For, even according to a combination with good compatibility, the diazonium salt capable of dissolving 1 g of a resin is about 2 mmol. Accordingly, it is very advantageous, if the solubility of the diazonium salt relative to the resin binder can be increased.

In view of the above situation, the present inventors have made various studies on improvement of solubility of the diazonium salt in the resin binder, and consequently found a phenomenon that the solubility of the diazonium salt can be surprisingly improved if a sulfonic acid derivative, phenol derivative or naphthol derivative is added in an amount of 0.5 to 5 moles per mole of the diazonium salt into the diazo photosensitive solution. While the solubility of the diazonium salt in 1 g of a resin binder is about 2 mmol at the highest as mentioned above, according to another embodiment of the present invention which employs a sulfonic acid derivative, phenol derivative or naphthol derivative, about 20 mmol, namely about 10-fold of solubility as compared with the case of no addition, was found to be obtained, and thus it is more preferred.

On the other hand, as the resin binder to be added in the diazo photosensitive solution of the present invention, there may be employed any of water-soluble resins and organic solvent-soluble resins. The water-soluble resins may include polyvinylpyrrolidone, copolymers of vinyl methyl ether and maleic anhydride, polyvinyl alcohol, cellulose derivatives such as methyl cellulose, hydroxymethyl cellulose, hydroxypropyl cellulose, hydroxypropylmethyl cellulose, natural resins such as gelatin, egg white, casein and shellac, etc. Further, the organic solvent soluble resin binders may include cellulose derivatives such as cellulose acetate butyrate resin, cellulose acetate, ethyl cellulose, polyvinylbutyral, polystyrene, cyclized polyisoprene, polyvinyl chloride, polyvinyl acetate, phenolic resins, polyester resin, acrylic resins such as copolymers of methyl methacrylate and methacrylic acid, copolymers of methyl acrylate and acrylic acid, but the present invention is not limited thereto.

The diazonium photosensitive solution may further contain other additives, for example, organic acids such as p-toluenesulfonic acid, sulfosalicylic acid, citric acid, tartaric acid, acetic acid, nicotinic acids as the pyrolysis stabilizer of the diazonium salt, or surfactants, defoaming agents and others as the materials for improving the coating characteristic, film forming property of the coated films, if desired.

For preparation of the diazo photosensitive solution, the above diazonium salt, the resin binder and the additives are dissolved in an appropriate solvent. Organic solvents may suitably be selected from alcohols, cellosolves, esters, ketones, halogenated hydrocarbons, toluene, xylene, THF and DMF. However, when providing a photosensitive film on a resist film, it is not preferred that a photosensitive solution dissolves or partially dissolves the resist film when the photosensitive solution was provided thereon to form a mixed layer comprising resist materials and a diazonium salt, since the aforasaid fact made lower the resolving property. Therefore, when the resist film consists of a water-soluble resist, the photosensitive solution to be coated thereon should preferably be composed of an organic solvent, a diazonium salt to be soluble therein and a resin binder as main components, and when the resist film consists of an organic solvent-soluble resist, the photosensitive solution to be applied thereon should preferably be composed of water, a water-soluble diazonium salt and a water-soluble resin binder as main components. However, it is not limited to the above when a solvent having substantially no solubility to the resist film is used in the photosensitive solution.

The proportions of the components constituting the diazo photosensitive solution should be such that the proportion of the diazonium salt formulated relative to the resin binder may be as near as possible to the limiting concentration at which the diazonium salt will be crystallized out in the solution state and during formation of the coated film, because the shielding ability against UV-ray can thereby preferably be made greater. In the case of coating by a spinner, etc., the viscosity of the photosensitive solution should desirably be within the range from 5 to 1000 cPs, preferably from 5 to 200 cPs.

The film thickness of the film of the diazo photosensitive solution, which is also related to the light-shielding ability of the film, cannot independently be determined, but it may be generally 500 Å (1 Å = 10 nm) to 5 µm, preferably 1000 Å to 2 µm. With a thickness less than 500 Å, pinholes may be generated, while a thickness over 5 µm will undesirably give rise to unfocused images.

After coating of the diazo photosensitive solution, drying is performed. The drying conditions should be determined primarily in view of the thermal stability of the resist material which is provided under the photosensitive film and the diazonium salt. Since diazonium salts begin to be decomposed usually at around 90 °C, the drying time should be made shorter at a temperature of 90 °C or higher. If the solvent remain in the photosensitive film, scattering of the exposure light will be increased, whereby resolution is undesirably lowered.

According to the method of the present invention, after formation of the photosensitive film as described above, pattern exposure is effected by irradiating a light with a wavelength of 300 nm or longer to 450 nm or less. Then, the photosensitive layer is removed, and subsequently the resist layer is developed to give a desired minutely worked pattern.

Further, the present inventors have made various studies about methods for coating of diazo photosensitive solutions on a resist film soluble in a diazo photosensitive solvent. As the result, it has now been found that by providing a transparent thin film which is difficultly soluble in the diazo photosensitive solution on the resist film without dissolving the resist film and applying the diazo photosensitive solution thereon, a diazo photosensitive soution comprising a solvent capable of dissolving the resist film can be used, and further confirmed that provision of such a transparent thin film has no adverse influence on the fading effect of the diazonium salt to give a minute pattern.

For providing the above transparent thin film, there may economically applied the method in which a polymer solution substantially transparent to a light having wavelength from 300 nm or longer to 450 nm or less is subjected to spin coating on a resist film to form a transparent thin film. However, it is required to satisfy the two conditions that said polymer solution must not dissolve substantially the lower layer of the resist film during spin coating, and that the transparent film obtained after drying must not be dissolved in the diazo photosensitive solution during the later step of coating thereof. As the polymer and the solvent system suited for these conditions, there may be employed polymer solutions of rubbery polymers such as cyclized polyisoprene, polybutadiene, neoprene dissolved in xylene, toluene, benzene and aqueous solutions of water-soluble polymers such as hydroxypropyl cellulose, methyl cellulose, hydroxypropylmethyl cellulose, polyvinyl alcohol, casein, gelatin, shellac and so on. The thickness of the transparent thin film obtained by spin coating of these polymer solutions should desirably be as thin as possible, but generally 0.03 to 3 µm, preferably 0.05 to 1 µm. In the case of a thickness less than 0.03 µm, pinholes will be formed to lose the meaning of formation of a transparent thin film. On the other hand, a thickness over 3 µm will undesirably give rise to unfocused images.

In the case of forming an intermediate layer comprising the above transparent thin film, the following effects can be obtained:

a) solvents of the diazo photosensitive solution can be selected without depending upon a kind of the resist film provided thereunder, thus variety kinds of diazonium salt can be used;
b) film thickness of the diazo photosensitive film can easily be controlled in the coating step;
c) removal of impurities in the diazo photosensitive solution can easily be done.

For forming a pattern on a substrate on which a photosensitive film having been formed a transparent thin film between a resist film and the photosensitive film has been formed, after pattern exposure, the diazo photosensitive film and the transparent thin film are peeled off in the order mentioned, and finally the resist film is subjected to development. For peeling off the diazo photosensitive film and the transparent thin film, the solvents employed for preparation of respective coating solutions are generally employed.

According to the present invention, there can be obtained an excellent effect that a minute pattern of 1 µm or less can be formed according to a simple method, while utilizing effectively the UV-ray exposure technique of the prior art, with good dimensional precision and stability, and its industrial effect is great.

The present invention is described in detail by referring to the following Examples.

Example 1

On a silicon wafer was provided a positive-type resist [esterified product of 1,2-naphthoquinone-diazide-5-sulfonic acid dissolved in m-cresol novolac resin (trade name OFPR-800, produced by Tokyo Oka Kogyo K.K.)] with a film thickness of 1 µm.

Next, a diazo photosensitive solution comprising the composition shown below was applied by rotary coating on the above positive-type resist, followed by drying at 80 °C for 10 minutes to provide a diazo photosensitive film with a thickness of 0.4 µm.

| | |
|---|---|
| 2,5-Diethoxy-4-morpholinobenzene-diazonium chloride 1/2 zinc chloride double salt (MW 382) | 20 mmol |
| Polyvinyl pyrrolidone (trade name: K90, produced by GAF Co.) | 10 g |
| Pure water | 200 ml |

Comparative exmple 1

On the other hand, comparative sample was prepared in the same manner as in Example 1 except that only the positive-type photoresist film was used.

Then, the sample thus obtained according to the present invention and the sample for comparative purpose were compared with each other with respect to their effects according to the following method.

The dimensions of the resist pattern after development when a pattern of 1 µm was exposed with various exposure second by means of a reduction-type projection aligner mounted with a 10 : 1 reducing lens with a numerical aperture of 0.35 were measured. The results are shown in Fig. 1 wherein the marks

—●—

represent the results of the present invention and the marks

—○—

those of Comparative example (the same as hereinbelow), which shows that the exposure second for obtaining a line width of 1 µm is prolonged to 2 seconds by use of the structure of the present invention, as contrasted to the prior art in which it is about 0.4 sec. However, examination of the dependency of line width on the exposure time after development gives the result that the slope of the straight line is about 1/3 in the

structure of the present invention as compared with the Comparative example, and therefore it can be understood that controllability of dimensions is greatly improved.

Also, the results of comparison with respect to dimensional precision are shown in Fig. 2. The dimensional precision ordinarily required is 3 σ, and it is stated to be within 10 % of its dimension. To determine the minimum line width, it is about 1.2 µm in the prior art method, and about 0.9 µm in the method of the present invention. Thus, improvement to a great extent can be recognized.

Example 2

The same experiment as in Example 1 was conducted except for employing 2,5-diethoxy-4-p-methoxyphenylthiobenzenediazonium chloride 1/2 zinc chloride double salt in place of the diazonium salt employed in Example 1, and the same pattern of 0.9 µm in the line width as in Example 1 was obtained.

Example 3

When the same experiment as in Example 1 was conducted except for employing the photosensitive solution having the following composition in place of the diazo photosensitive solution employed in Example 1, a clear pattern of 0.9 µm in the line width was obtained. The viscosity of the diazo photosensitive solution was 50 cPs.

| | |
|---|---|
| 2,5-Diethoxy-4-p-methoxybenzoylaminobenzenediazonium chloride 1/2 zinc double salt | 20 mmol |
| Copolymer of vinyl methyl ether and maleic anhydride (trade name: GANTREZ AN-139, produced by GAF Co.) | 10 g |
| Pure water | 200 ml |

Example 4

The same experiment is in Example 3 was conducted except for employing 3-methoxy-4-pyrrolidinylbenene chloride 1/2 zinc chloride double salt as the diazonium salt in the diazo photosensitive solution employed in Example 3. As the result, a clear pattern of 0.8 to 0.9 µm in the line width was obtained.

Comparative example 2

The following mixture was prepared as a solution containing a fading dye.

| | |
|---|---|
| Rhodamine 6G | 10 mmol |
| Polyvinylpyrrolidone (trade name: K-90, produced by GAF Co.) | 10 g |
| Pure water | 200 ml |

This dye solution was applied on the positive-type resist film as employed in Example 1 to provide a dye film with a dried film thickness of 0.7 µm. By varying the exposure time similarly as in Exampel 1, patterns were evaluated. As the result, it proved to take unpractically long time of 16 minutes or longer for obtainining a pattern of 1 µm.

Comparative example 3

On a silicon wafer was provided an ordinary negative-type resist [2,6-bis-(4-azidobenzal)cyclohexanone derivative dissolved in cyclized polyisoprene (trade name: OMR-83, produced by Tokyo Oka K.K.)] with a

film thickness of 1.0 µm. Next, the positive-type resist as used in Example 1 was applied on the resist film to a thickness of 0.5 µm. Exposure was effected by means of a reduction-type projection aligner mounted with 1 : 1 mirror (trade name: PLA-520, produced by Canon K.K.). Exposure was effected by varying the exposure time, and the positive-type resist was removed with cellosolve acetate after exposure, followed by developing with a xylene type developer, and the patterns obtained were evaluated. As the result, it was found that no minute pattern of 2.0 µm or less was obtained irrespectively of whether there was the positive-type resist film or not.

Example 5

On a silicon wafer was formed a positive-type resist (trade name: OFPR-800, produced by Tokyo Oka K.K.) to a film thickness of 1 µm.

Next, by use of a 5 % xylene solution of cyclized polyisoprene, a transparent thin film with a thickness of 0.1 µm was formed according to the rotary coating method on the above resist film. Next, a diazo photosensitive solution having the composition shown below was prepared, and the photosensitive solution was applied according to the rotary coating method to provide a diazo photosensitive film with a film thickness of 0.4 µm on the above transparent thin film.

For the thus prepared sample, patterns were formed following the method as described in Example 1. As the result, the exposure time for obtaining a pattern with a 1 µm line width was 2 seconds. On the other hand, the minimum line width satisfying the dimensional precision was 3 $\sigma$, and the condition within 10 % was found to be about 0.9 µm, which was by far superior to 1.2 µm of the prior art comprising only the positive-type resist.

Example 6

By use of 2,5-diethoxy-4-morpholinobenzenediazonium tetrafluoroborate (absorption peak wavelength: 404 nm) in place of the diazonium salt employed in Example 5, patterns were formed in the same manner as in Example 5. As the result, a pattern of 0.9 µm was obtained.

Example 7

As the result of formation of the patterns according to the same method as in Example 5 by use of the photosensitive solution having the composition as shown below as the diazo photosensitive solution, a clear pattern of 0.8 µm could be obtained.

| | |
|---|---|
| 3-Methoxy-4-pyrrolidinylbenzene-diazonium tetrafluoroborate (absorption peak wavelength: 411 nm) | 20 mmol |
| Polyvinylbutyral resin (trade name: Ethlec BMS, produced by Sekisui Kagaku K.K.) | 10 g |
| Mixed solvent of cellosolve acetate : methyl ethyl ketone = 8 : 2 | 200 ml |

Example 8

The same experiment as in Example 5 was repeated by use of an aqueous 10 % solution of hydroxypropyl cellulose as the polymer solution for formation of a transparent thin film. As the result, a clear pattern with the minimum line width of 0.9 µm was obtained.

Example 9

On the resist film of a positive-type resist (trade name OFPR-800, produced by Tokyo Oka K.K.) formed on a silicon wafer to a film thickness of 1 µm, a transparent thin film with a film thickness of 0.1 µm was provided by use of a 5 % xylene solution of a cyclilzed polyisoprene.

Next, a diazo photosensitive solution having the composition shown below was prepared and applied on the above tranparent thin film according to the rotary coating method to a film thickness of 0.4 µm. The viscosity of the photosensitive solution was 30 cPs. When patterns were formed following Example 1, the exposure time for obtaining a pattern with a line width of 1 µm was about 4 seconds. Also, the minimum line width satisfying the dimensional precision of 3 σ, and the condition within 10 % was about 0.7 µm.

| | |
|---|---|
| 2,5-Dibutoxy-4-morpholinobenzene diazonium tetrafluoroborate | 100 mmol |
| p-Toluene solfonic acid | 100 mmol |
| Cellulose butyroacetate | 10 g |
| Mixed solvent of cellosolve acetate : methyl ethyl ketone = 8 : 2 in volume ratio | 200 ml |

Example 10

As the result of pattern formation conducted in the same manner as in Example 15 by use of 2,5-diethoxy-4-morpholinobenzenediazonium tetrafluoroborate (absorption peak wavelength: 404 nm) as the diazonium salt, a pattern of 0.7 µm in the line width was obtained.

Example 11

As the result of pattern formation in the same manner as in Example 9 by use of the diazo photosensitive solution having the composition shown below, a clear pattern of 0.7 µm in the line width was obtained.

| | |
|---|---|
| 3-Methoxy-4-pyrrolidylbenzenediazonium tetrafluoroborate (absorption peak wavelength: 411 nm) | 200 mmol |
| p-Hydroxybenzenesulfonic acid | 230 mmol |
| Polyvinylbutyral resin (trade name: Ethlec BMS, produced by Sekisui Kagaku K.K.) | 10 g |
| Mixed solvent of cellosolve acetate : methyl ethyl ketone = 8 : 2 in volume ratio | 200 ml |

Example 12

The same experiment as in Example 9 was carried out by use of an aqueous 10 % solution of hydroxypropyl cellulose as the polymer solution for formation of a transparent thin film. As the result, a clear pattern with the minimum line width of 0.7 µm was obtained.

Example 13

On the positive-type resist of Example 9 was applied a diazo photosensitive solution having the following composition to provide a diazo photosensitive film with a film thickness of 0.4 µm thereon.

| | |
|---|---|
| 2,5-Diethoxy-4-morpholinobenzene-diazonium chloride 1/2 zinc chloride double salt | 200 mmol |
| p-Toluenesulfonic acid | 230 mmol |
| Polyvinylpyrrolidone (trade name: K-90, produced by GAF Co.) | 10 g |
| Pure water | 200 ml |

Thereafter, similarly as in Example 9, pattern formation was performed to obtain a clear pattern of 0.7 µm in the line width.

Example 14

On a silicon wafer was provided a positive-type resist [esterified product of 1,2-naphthoquinone-diazide-5-sulfonic acid dissolved in m-cresol novolac resin (trade name: OFPR-800, produced by Tokyo Oka Kogyo K.K.)] with a film thickness of 1 µm.

Next, a diazo photosensitive solution comprising the composition shown below was applied by rotary coating on the above positive-type resist, followed by drying at 80 °C for 10 minutes to provide a diazo photosensitive film with a thickness of 0.4 µm.

| | |
|---|---|
| 2-(4'-Methoxyphenyl)-6-methyl-1,3-benzotriazole-5-diazonium tetrafluoroborate | 20 mmol |
| Polystyrene (Mw = 40000) | 10 g |
| Xylene | 200 ml |

Then, on this photosensitive film, a pattern of 1.2 µm was exposed by means of a reduction-type projection aligner mounted with a 10 : 1 reducing projecting lens with a numerical aperture of 0.35 by varying the exposure seconds. The results of measurement of the dimensions of the resist patterns after development are shown in Fig. 3. For comparative purpose, the results when no photosensitive film was provided were also shown together.

As apparently seen from Fig. 3, the dependency of the line width on the exposure time after development gives the result that the slope of the straight line is about 1/3 in the structure of the present invention as compared with the case of Comparative example, and therefore it has been found that controllability of pattern dimensions is greatly improved.

Also, when comparison was made with respect to resolution, it was found that the minimum line width which can maintain good cross-sectional shape of pattern was 0.7 µm in the case of Example, as contrasted to 1.0 µm of Comparative example.

Example 15

Pattern formation was carried out in the same manner as in Example 14 except for employing a photosensitive solution having the composition shown below.

| | |
|---|---|
| 2-Naphthyl-1,3-benzotriazole-5-diazonium-hexafluorophosphate | 20 mmol |
| Cyclized polyisoprene (unsaturation degree: 6 mmol/g) | 10 g |
| Xylene | 200 ml |

As the result, a clear pattern of 0.8 µm in the line width was obtained.

Example 16

On a silicon wafer was provided a positive-type resist [esterified product of 1,2-naphthoquinone-diazide-5-sulfonic acid dissolved in m-cresol novolac resin (trade name: OFPR-800, produced by Tokyo Oka Kogyo K.K.)] to a film thickness of 1 µm.

Next, a diazo photosensitive solution comprising the composition shown below was applied by rotary coating on the above positive-type resist, followed by drying at 80 °C for 10 minutes to provide a diazo photosensitive film with a thickness of 0.4 µm.

| | |
|---|---|
| N,N-bis-(4-diazophenyl)amine tetrafluoroborate | 20 mmol |
| Polystyrene (Mw = 10000) | 10 g |
| Xylene | 200 ml |

Comparative example 4

A sample was prepared according to entirely the same procedure as in Example 16, except for providing no diazo photosensitive film.

Then, the sample thus obtained according to the present invention and the sample comprising only the positive-type photoresist film were compared with each other with respect to their effects according to the same method as in Example 16 to obtain the results as shown in Fig. 4.

It is shown that the exposure second for obtaining a line width of 1.2 µm is prolonged to 1.3 seconds by use of the structure of the present invention, as contrasted to the prior art in which it is about 0.3 sec. However, examination of the dependency of line width on the exposure time after development gives the result that the slope of the straight line is about 1/3 with smaller deviation from the mask dimension in the structure of the present invention as compared with the Comparative example, and therefore it can be understood that controllability of dimensions is greatly improved.

Also, as the result of comparison with respect to resolution, it was found that the minimum line width which can maintain good cross-sectional shape of pattern was 0.7 µm in the case of Example, as contrasted to 1.0 µm of Comparative example. Thus, improvement to a great extent was observed in the present invention.

Example 17

The same experiment as in Example 16 was carried out except for using the diazo photosensitive solution having the composition shown below. As the result, a clear pattern having a line width of 0.7 µm was obtained.

| | |
|---|---|
| N,N-bis-(3-methoxy-4-diazophenyl)-amine tetrafluoroborate | 20 mmol |
| Alkyl-modified phenol novolac resin (trade name: CKM-2400, produced by Showa Union Gosei Co.) | 10 g |
| Xylene | 200 ml |

Example 18

On a silicon wafer was provided a positive-type resist film [esterified product of 1,2-naphthoquinone-diazide-5-sulfonic acid dissolved in m-cresol novolac resin (trade name: OFPR-800, produced by Tokyo Oka

Kogyo K.K.)] to a film thickness of 1.2 µm.

Next, a diazo photosensitive solution comprising the composition shown below was applied by rotary coating on the above positive-type resist film, followed by drying at 80 °C for 10 minutes to provide a diazo photosensitive film with a thickness of 0.5 µm.

| | |
|---|---|
| 3-Methoxy-4-pyrrolidylbenzenediazonium-sulfosalicylic acid salt | 20 mmol |
| Cellulose acetate | 5 g |
| Trichloroethane | 200 ml |

Comparative example 5

A sample was prepared according to entirely the same procedure as in Example 18 except for providing no diazo photosensitive film.

Then, the sample thus obtained according to the present invention and the sample comprising only the positive-type photoresist film were compared with each other with respect to their effects according to the following method.

The dimensions of the resist pattern after development when a pattern of 1.2 µm was exposed (wavelength: 436 nm) for various exposure seconds by means of a reducing projecting exposure device mounted with a 10:1 reducing projecting lens with a numerical aperture of 0.35 were measured. The results are shown in Fig. 5.

As apparently seen from Fig. 5, the exposure second for obtaining a line width of 1.2 µm is prolonged to about 1.2 seconds by the present invention, as contrasted to the prior art in which it is about 0.3 sec. Also, examination of the dependency of line width on the exposure time after development gives the result that the slope of the straight line is about 1/2 with smaller deviation from the mask dimension in the present invention as compared with the Comparative example, and therefore it can be understood that controllability of dimensions is greatly improved.

Also, as the result of comparison with respect to resolution, it was found that the minimum line width which can maintain good cross-sectional shape of pattern was 0.6 µm in the case of Example, as contrasted to 1.0 µm of Comparative example. Thus, improvement to a great extent was confirmed in the present invention.

Example 19

On a silicon wafer was provided a positive-type resist [esterified product of 1,2-naphthoquinone-diazide-5-sulfonic acid dissolved in m-cresol novolac resin (trade name: OFPR-800, produced by Tokyo Oka Kogyo K.K.)] to a film thickness of 1.2 µm.

Next, a diazo photosensitive solution comprising the composition shown below was applied by rotary coating on the above positive-type resist, followed by drying at 80 °C for 10 minutes to provide a diazo photosensitive film with a thickness of 0.4 µm.

| | |
|---|---|
| 2,5-Diethoxy-4-morpholinobenzene-diazonium tetrafluoroborate | 60 mmol |
| p-tert-Butylphenol | 50 mmol |
| Alkyl-modified phenol novolac resin (trade name: KM-2400, produced by Showa Union Gosei Co.) | 10 g |
| Xylene | 200 ml |

Then, the photosensitive film was exposed by means of a reduction-type projection aligner mounted with a 10 : 1 reducing lens with a numerical aperture of 0.35 and, after development, the resist pattern was observed. For comparison, the same exposure was carried out also in the case of providing no photosensitive film of the present invention. As the result, in the case of the sample of the present invention, a pattern of 0.8 μm could be resolved, and the cross-sectional shape of the pattern was also found to be very good. In contrast, in the case of Comparative example, the resolution was 1.2 μm.

## Claims

1. A composition for pattern formation comprising a resin binder, a solvent and at least one photosensitive diazonium salt selected from the formulae (I) - (VI) shown below:

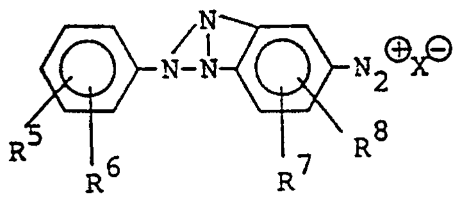

(I')

wherein $R^5$, $R^6$, $R^7$ and $R^8$ may be either identical or different and each represent a hydrogen atom, a halogen atom, an amino group, a sulfo group, a carboxyl group, an alkyl group, an alkoxy group, a dialkylamino group, an alkylmercapto group or an acyl group each having 1 to 6 carbon atoms, an aryl group or an aralkyl group each having 6 to 12 carbon atoms; and X represents a halogen ion, a sulfate ion or an anion consisting of a halide of either boron, phosphorus, zinc, arsenic, aluminum, iron or antimony,

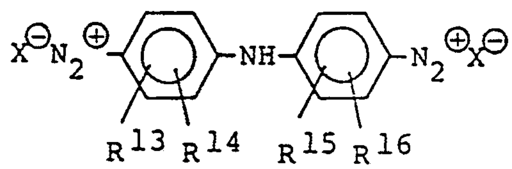

(II)

wherein $R^{13}$, $R^{14}$, $R^{15}$ and $R^{16}$ each represent a hydrogen atom, a halogen atom, an alkyl group, an alkenyl group, an alkoxy group, an aryl group, an aralkyl group, an amino group, a dialkylamino group, an alkylmercapto group, an acyl group, a sulfo group or a carboxyl group; and X represents an anion capable of forming a diazonium salt,

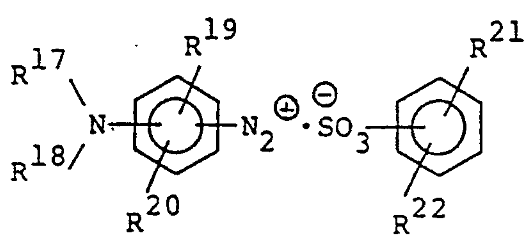

(III)

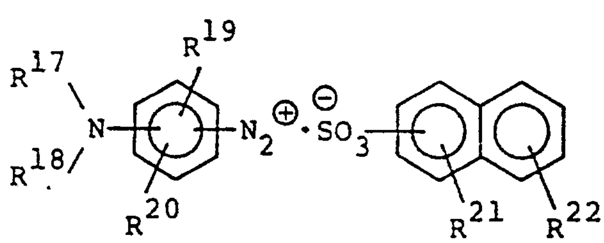

(IV)

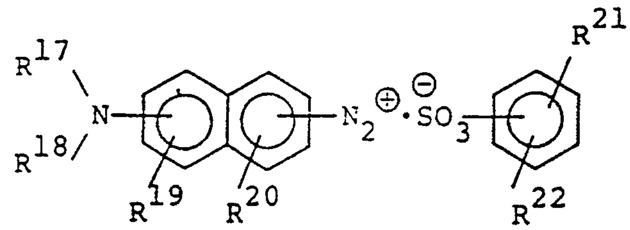

(V)

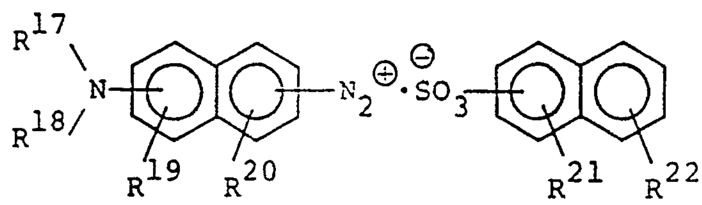

(VI)

wherein $R^{17}$ and $R^{18}$ each represent a hydrogen atom, an alkyl group having 1 to 6 carbon atoms, a phenyl group, or $R^{17}$ and $R^{18}$ taken together may be cyclized through a carbon, oxygen or nitrogen atom; $R^{19}$ and $R^{20}$ each represent a hydrogen atom, a halogen atom, an alkyl group, an alkoxy group or an alkenyl group each having 1 to 6 carbon atoms; $R^{21}$ and $R^{22}$ each represent a hydrogen atom, a hydroxyl group, a carboxyl group, a sulfo group, an alkyl group or an alkoxy group each having 1 to 6 carbon atoms, an amino group, a nitro group or a benzoyl group.

**2.** A composition for pattern formation according to claim 1, wherein said diazonium salt is selected from the group consisting of the compounds of the formulae (III), (IV), (V ) and (VI ).

**3.** A composition for pattern formation according to claim 1 or claim 2, wherein the resin binder is selected from the group consisting of polyvinylpyrrolidone, copolymers of vinyl methyl ether and maleic anhydride, polyvinyl alcohol, methyl cellulose, hydroxymethyl cellulose, hydroxypropyl cellulose, hydroxypropylmethyl cellulose, gelatin, egg white, casein, shellac, cellulose acetate butyrate, cellulose acetate, ethyl cellulose, polystyrene, cyclized polyisoprene, polyvinyl chloride, polyvinyl acetate, phenolic resins, polyester resin, copolymers of methyl methacrylate and methacrylic acid, and copolymers of methyl acrylate and acrylic acid.

**4.** A composition for pattern formation according to any preceding claim further containing at least one selected from the group consisting of benzenesulfonic acid derivatives of the formula (X), the naphthosulfonic acid derivatives of the formula (XI), the phenol derivatives of the formula (XII) and the naphthol derivatives of the formula (XIII):

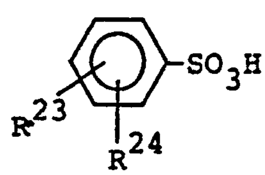

(X)

wherein $R^{23}$ and $R^{24}$ may be either identical or different and each represent a hydrogen atom, a halogen atom, a hydroxyl group, a carboxyl group or an alkyl group,

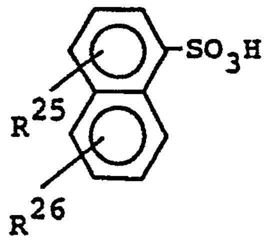

(XI)

wherein $R^{25}$ and $R^{26}$ may be either identical or different and each represent a hydrogen atom, a halogen atom, a hyroxyl group, a carboxyl group, a sulfo group, an alkyl group having 1 to 5 carbon atoms, an amino group or a nitro group,

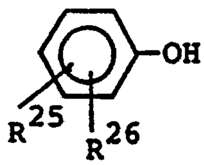

(XII)

wherein $R^{25}$ and $R^{26}$ have the same meanings as defined above,

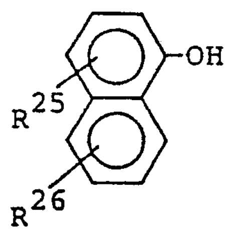

(XIII)

wherein $R^{25}$ and $R^{26}$ have the same meanings as defined above.

5. A composition for pattern formation according to Claim 4, wherein the compounds represented by the formulae (X) to (XIII) are contained in an amount of 0.5 to 5.0 mole per mole of the photosensitive diazonium salt.

6. A pattern forming method comprising the steps of:
providing a resist film on a substrate;
providing a photosensitive film containing a photosensitive diazonium salt on the resist film; and then
subjecting the resultant composite to pattern exposure by use of a light to which both of the resist film and the photosensitive diazonium salt are sensitive,

wherein the photosensitive diazonium salt is at least one selected from the group consisting of the compounds of the formulae (I) - (VI) as defined in claim 1.

7. A pattern forming method according to claim 6, wherein said diazonium salt is selected from the group consisting of the compounds of the formulae (IV), (VI), (V) and ( III).

8. A pattern forming method according to Claim6 or claim 7 wherein the photosensitive solution for forming the photosensitive film contains at least one selected from the group consisting of benzenesulfonic acid derivatives of the formula (X), the naphthosulfonic acid derivatives of the formula (XI), the phenol derivatives of the formula (XII) and the naphthol derivatives of the formula (XIII), said formulae (X)-(XIII) being as defined in claim 4.

9. A pattern forming method according to Claim 8, wherein the compounds represented by the formulae (X) to (XIII) are contained in an amount of 0.5 to 5.0 mole per mole of the photosensitive diazonium salt.

10. A pattern forming method according to Claim 6, wherein the light has a wavelength of 300 nm or longer to 450 nm or less.

11. A pattern forming method according to Claim 6, including the step of forming a transparent thin film, which does not dissolve said resist film and is also difficultly soluble in the photosensitive film, on the resist film.

## Revendications

1. Composition pour la formation de dessin, comprenant un liant de résine, un solvant et au moins un sel de diazonium photosensible choisi parmi les formules (I) à (VI) ci-dessous :

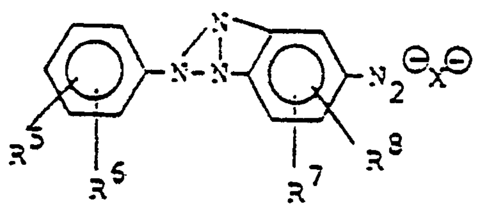

(I)

où $R^5$, $R^6$, $R^7$, et $R^8$ peuvent être identiques ou différents et représentent chacun un atome d'hydrogène, un atome d'halogène, un groupe amino, un groupe sulfo, un groupe carboxyle, un groupe alkyle, un groupe alcoxy, un groupe dialkylamino, un groupe alkylmercapto ou un groupe acyle ayant chacun 1 à 6 atomes de carbone, un groupe aryle ou un groupe aralkyle ayant chacun 6 à 12 atomes de carbone; et X représente un ion halogène, un ion sulfate ou un anion constitué d'un halogénure de bore, de phosphore, de zinc, d'arsenic, d'aluminium, de fer ou d'antimoine,

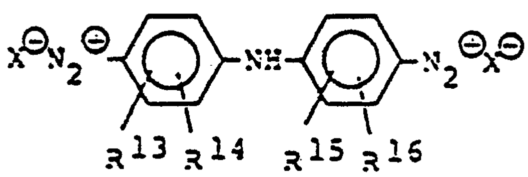

(II)

où $R^{13}$, $R^{14}$, $R^{15}$ et $R^{16}$ représentent chacun un atome d'hydrogène, un atome d'halogène, un groupe alkyle, un groupe alcényle, un groupe alcoxy, un groupe aryle, un groupe aralkyle, un groupe amino, un groupe dialkylamino, un groupe alkylmercapto, un groupe acyle, un groupe sulfo, ou un groupe carboxyle; et X représente un anion capable de former un sel de diazonium,

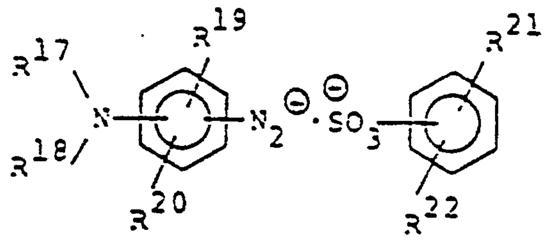

(III)

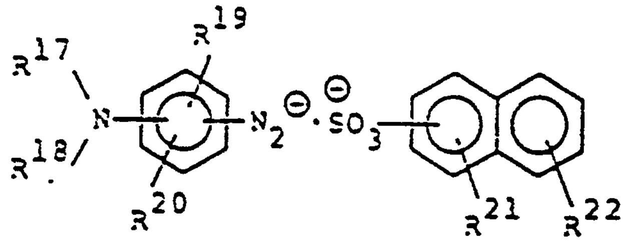

(IV)

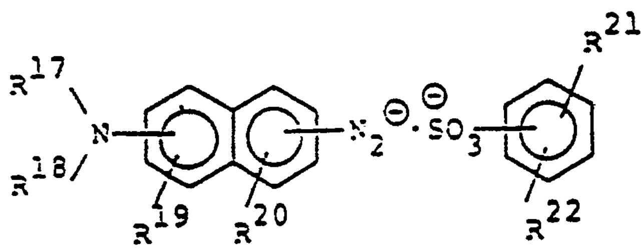

(V)

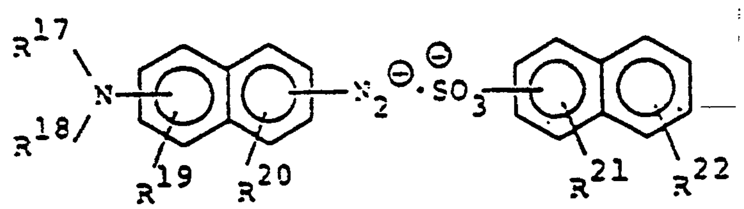

(VI)

où $R^{17}$ et $R^{18}$ représentent chacun un atome d'hydrogène, un groupe alkyle en $C_1$ à $C_6$, un groupe phényle, ou bien $R^{17}$ et $R^{18}$ pris conjointement peuvent être cyclisés par un atome de carbone, d'oxygène ou d'azote; $R^{19}$ et $R^{20}$ représentent chacun un atome d'hydrogène, un atome d'halogène, un groupe alkyle, un groupe alcoxy ou un groupe alcényle ayant chacun 1 à 6 atomes de carbone; $R^{21}$ et $R^{22}$ représentent chacun un atome d'hydrogène, un groupe hydroxyle, un groupe carboxyle, un groupe sulfo, un groupe alkyle ou un groupe alcoxy ayant chacun 1 à 6 atomes de carbone, un groupe amino, un groupe nitro ou un groupe benzoyle.

**2.** Composition pour la formation de dessin selon la revendication 1, dans laquelle ce sel de diazonium est choisi parmi les composés répondant aux formules (III), (IV), (V) et (VI).

**3.** Composition pour la formation de dessin selon les revendications 1 ou 2, dans laquelle le liant de résine est choisi parmi la polyvinylpyrrolidone, des copolymères de l'éther vinyl méthylique et de l'anhydride maléique, l'alcool polyvinylique, la méthyl cellulose, l'hydroxyméthyl cellulose, l'hydroxypropyl cellulose, l'hydroxypropylméthyl cellulose, la gélatine, le blanc d'oeuf, la caséine, la gomme laque, l'acétate butyrate de cellulose, l'acétate de cellulose, l'éthyl cellulose, le polystyrène, le polyisoprène cyclisé, le chlorure de polyvinyle, l'acétate de polyvinyle, les résines phénoliques, les résines polyesters, les copolymères du méthacrylate de méthyle et de l'acide méthacrylique et les copolymères de l'acrylate de méthyle et de l'acide acrylique.

**4.** Composition pour la formation de dessin selon l'une quelconque des revendications précédentes,

contenant au moins un composé choisi parmi des dérivés de l'acide benzènesulfonique répondant à la formule (X) des dérivés de l'acide naphtosulfonique répondant à la formule (XI), des dérivés du phénol répondant à la formule (XII) et des dérivés du naphtol répondant à la formule (XIII):

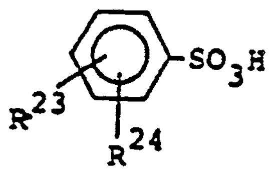

(X)

où $R^{23}$ et $R^{24}$ peuvent être identiques ou différents et représentent chacun un atome d'hydrogène, un atome d'halogène, un groupe hydroxyle, un groupe carboxyle ou un groupe alkyle,

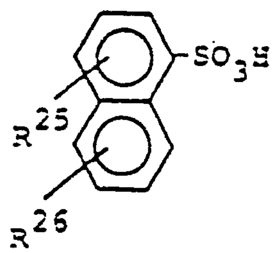

(XI)

où $R^{25}$ et $R^{26}$ peuvent être identiques ou différents et représentent chacun un atome d'hydrogène, un atome d'halogène, un groupe hydroxyle, un groupe carboxyle, un groupe sulfo, un groupe alkyle en $C_1$ à $C_5$ , un groupe amino ou un groupe nitro,

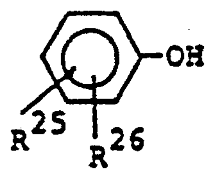

(XII)

où $R^{25}$ et $R^{26}$ ont les mêmes significations que ci-dessus,

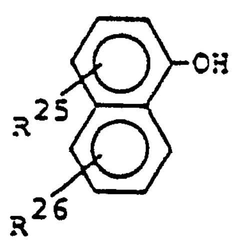

(XIII)

où $R^{25}$ et $R^{26}$ ont les mêmes significations que ci-dessus.

**5.** Composition pour la formation de dessin selon la revendication 4, dans laquelle les composés représentés par les formules (X) à (XIII) sont contenus dans la proportion de 0,5 à 5,0 moles par mole du sel de diazonium photosensible.

**6.** Procédé de formation de dessin comprenant les stades consistant à :

- déposer un film de photoréserve sur un substrat;
- déposer un film photosensible contenant un sel de diazonium photosensible sur le film de

photoréserve; puis

- soumettre le composite obtenu à une exposition de dessin en utilisant une lumière à laquelle le film de photoréserve et le sel de diazonium photosensible sont tous deux sensibles; dans lequel le sel de diazonium photosensible est au moins un sel choisi parmi les composés répondant aux formules (I)-(VI) tels que définis dans la revendication 1.

7. Procédé de formation de dessin selon la revendication 6, dans lequel ce sel de diazonium est choisi parmi les composés répondant aux formules (IV), (VI), (V) et (III).

8. Procédé de formation de dessin selon les revendications 6 ou 7, dans lequel la solution photosensible pour former le film photosensible contient au moins un composé choisi pari les dérivés de l'acide benzènesulfonique répondant à la formule (X), les dérivés de l'acide naphtosulfonique répondant à la formule (XI), les dérivés du phénol répondant à la formule (XII) et les dérivés du naphtol répondant à la formule (XIII), ces formules (X) à (XIII) étant telles que définies dans la revendication 4.

9. Procédé de formation de dessin selon la revendication 8, dans lequel les composés représentés par les formules (X) à (XIII) sont contenus dans une proportion de 0,5 à 5,0 moles par mole du sel de diazonium photosensible.

10. Procédé de formation de dessin selon la revendication 6, dans lequel la lumière a une longueur d'onde de 300 nm ou davantage jusqu'à 450 nm ou moins.

11. Procédé de formation de dessin selon la revendication 6, comprenant le stade de formation d'un film transparent fin qui ne dissout pas ce film de photoréserve et qui est également peu soluble dans le film photosensible, sur le film de photoréserve.

**Patentansprüche**

1. Zusammensetzung zum Bilden von Mustern, umfassend ein Harzbindemittel, ein Lösungsmittel und zumindest ein lichtempfindliches Diazoniumsalz, ausgewählt aus den unten dargestellten Formeln (I) bis (VI)

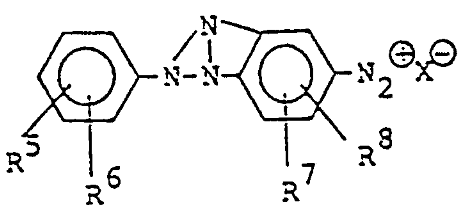

(I)

worin $R^5$, $R^6$, $R^7$ und $R^8$ entweder identisch oder verschieden voneinander sein können und jeweils ein Wasserstoffatom, ein Halogenatom, eine Aminogruppe, eine Sulfogruppe, eine Carboxylgruppe, eine Alkylgruppe, eine Alkoxygruppe, eine Dialkylaminogruppe, eine Alkylmercaptogruppe oder eine Acylgruppe, die jeweils 1 bis 6 Kohlenstoffatome aufweisen, eine Arylgruppe oder eine Aralkylgruppe mit jeweils 6 bis 12 Kohlenstoffatomen bedeuten; und worin X ein Halogenion, ein Sulfation oder ein Anion darstellt, welches aus einem Halogenid, entweder von Bor, Phosphor, Zink, Arsen, Aluminium, Eisen oder antimon, besteht;

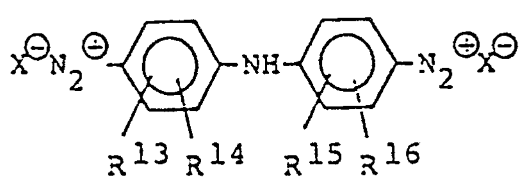

(II)

worin $R^{13}$, $R^{14}$, $R^{15}$ und $R^{16}$ jeweils ein Wasserstoffatom, ein Halogenatom, eine Alkylgruppe, eine Alkenylgruppe, eine Alkoxygruppe, eine Arylgruppe, eine Aralkylgruppe, eine Aminogruppe, eine Dialkylaminogruppe, eine Alkylmercaptogruppe, eine Acylgruppe, eine Sulfogruppe oder eine Carboxylgruppe darstellen und worin X ein Anion bedeutet, welches ein Diazoniumsalz bilden kann;

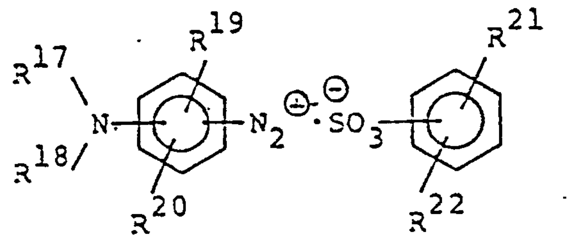

(III)

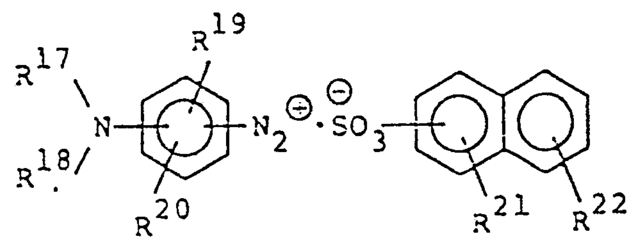

(IV)

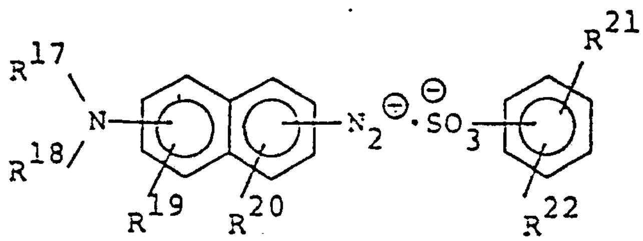

(V)

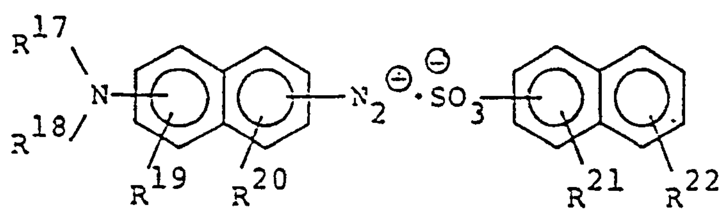

(VI)

worin $R^{17}$ und $R^{18}$ jeweils ein Wasserstoffatom, eine Alkylgruppe mit 1 bis 6 Kohlenstoffatomen, eine Phenylgruppe darstellen oder worin $R^{17}$ und $R^{18}$ zusammen durch ein Kohlenstoff-, Sauerstoff- oder Stickstoffatom zu einem Ring geschlossen sein können; worin $R^{19}$ und $R^{20}$ jeweils ein Wasserstoffatom, ein Halogenatom, eine Alkylgruppe, eine Alkoxygruppe oder eine Alkenylgruppe, jeweils mit 1 bis 6 Kohlenstoffatomen, darstellen; worin $R^{21}$ und $R^{22}$ jeweils ein Wasserstoffatom, eine Hydroxylgruppe, eine Carboxylgruppe, eine Sulfogruppe, eine Alkylgruppe oder eine Alkoxygruppe, jeweils mit 1 bis 6 Kohlenstoffatomen, eine Aminogruppe, eine Nitrogruppe oder eine Benzoylgruppe darstellen.

2. Zusammensetzung zum Bilden von Mustern nach Anspruch 1, dadurch **gekennzeichnet,** dass das Diazoniumsalz aus der Gruppe ausgewählt ist, die aus den Verbindungen der Formeln (III), (IV), (V) und (VI) besteht.

3. Zusammensetzung zum Bilden von Mustern nach Anspruch 1 oder 2, dadurch **gekennzeichnet,** dass das Harzbindemittel aus der Gruppe ausgewählt ist, die aus Polyvinylpyrrolidon, Copolymeren von Vinylmethylether und Maleinsäureanhydrid, Polyvinylalkohol, Methylzellulose, Hydroxymethylzellulose,

Hydroxypropylzellulose, Hydroxypropylmethylzellulose, Gelatine, Eiweiss, Kasein, Shellak, Zelluloseacetatbutyrat, Zelluloseacetat, Ethylzellulose, Polystyrol, zyklisiertes Polyisopren, Polyvinylchlorid, Polyvinylacetat, Phenolharzen, Polyesterharz, Copolymeren von Methylmethacrylat und Methacrylsäure und Copolymeren von Methylacrylat und Acrylsäure besteht.

**4.** Zusammensetzung zum Bilden von Mustern nach einem der vorhergehenden Ansprüche, dadurch **gekennzeichnet,** dass sie weiterhin zumindest eine Verbindung umfasst, ausgewählt aus der Gruppe, die aus Benzolsulfonsäurederivaten der Formel (X), Naphthosulfonsäurederivaten der Formel (XI), Phenolderivaten der Formel (XII) und den Naphtholderivaten der Formel (XIII) besteht

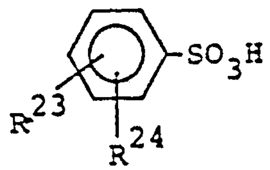

(X)

worin $R^{23}$ und $R^{24}$ entweder identisch oder verschieden sein können und jeweils ein Wasserstoffatom, ein Halogenatom, eine Hydroxylgruppe, eine Carboxylgruppe oder eine Alkylgruppe darstellen;

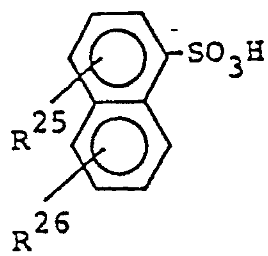

(XI)

worin $R^{25}$ und $R^{26}$ entweder identisch oder verschieden sind und jeweils ein Wasserstoffatom, ein Halogenatom, eine Hydroxylgruppe, eine Carboxylgruppe, eine Sulfogruppe, eine Alkylgruppe mit 1 bis 5 Kohlenstoffatomen, eine Aminogruppe oder eine Nitrogruppe darstellen;

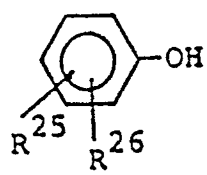

(XII)

worin $R^{25}$ und $R^{26}$ die gleichen Bedeutungen, wie oben definiert, aufweisen;

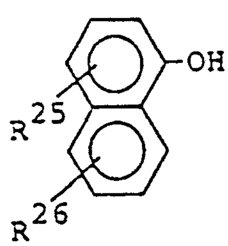

(XIII)

worin $R^{25}$ und $R^{26}$ die gleichen Bedeutungen, wie oben definiert, aufweisen.

**5.** Zusammensetzung zum Bilden von Mustern nach Anspruch 4, dadurch **gekennzeichnet,** dass die Verbindungen, die durch die Fomreln (X) bis (XIII) dargestellt sind, in einer Menge von 0,5 bis 5,0

Mol/Mol des lichtempfindlichen Diazoniumsalzes enthalten sind.

**6.** Verfahren zum Bilden von Mustern mit folgenden Schritten:

Vorsehen eines Resistfilmes auf einem Substrat;

Vorsehen eines lichtempfindlichen Filmes, der ein lichtempfindliches Diazoniumsalz umfasst, auf dem Resistfilm; und dann

Durchführen einer Musterexposition mit der resultierenden Zusammensetzung durch die Verwendung eines Lichtes, auf das sowohl der Resistfilm als auch das lichtempfindliche Diazoniumsalz empfindlich reagieren;

wobei das lichtempfindliche Diazoniumsalz zumindest eine Verbindung darstellt, die aus der Gruppe ausgewählt ist, die aus den Verbindungen der Formeln (I) bis (VI) nach Anspruch 1 besteht.

**7.** Verfahren zum Bilden von Mustern nach Anspruch 6, dadurch **gekennzeichnet,** dass das Diazoniumsalz aus der Gruppe ausgewählt ist, die aus den Verbindungen der Formeln (IV), (VI), (V) und (III) besteht.

**8.** Verfahren zum Bilden von Mustern nach Anspruch 6 oder 7, dadurch **gekennzeichnet,** dass die lichtempfindliche Lösung zur Bildung des lichtempfindlichen Filmes zumindest eine Verbindung umfasst, ausgewählt aus der Gruppe, die aus Benzolsulfonsäurederivaten der Formel (X), den Naphthosulfonsäurederivaten der Formel (XI), den Phenolderivaten der Formel (XII) und den Naphtholderivaten der Formel (XIII) besteht, wobei die Formeln (X) bis (XIII) in Anspruch 4 definiert sind.

**9.** Verfahren zum Bilden von Mustern nach Anspruch 8, dadurch **gekennzeichnet,** dass die Verbindungen, die durch die Formeln (X) bis (XIII) dargestellt sind, in einer Menge von 0,5 bis 5,0 Mol/Mol des lichtempfindlichen Diazoniumsalzes enthalten sind.

**10.** Verfahren zum Bilden von Mustern nach Anspruch 6, dadurch **gekennzeichnet,** dass das Licht eine Wellenlänge von 300 nm oder länger bis 450 nm oder weniger aufweist.

**11.** Verfahren zum Bilden von Mustern nach Anspruch 6, dadurch **gekennzeichnet,** dass es den Schritt aufweist, dass ein transparenter, dünner Film, der den Resistfilm nicht auflöst und der ebenfalls in dem lichtempfindlichen Film schwer löslich ist, auf dem Resistfilm gebildet wird.

# FIG.1

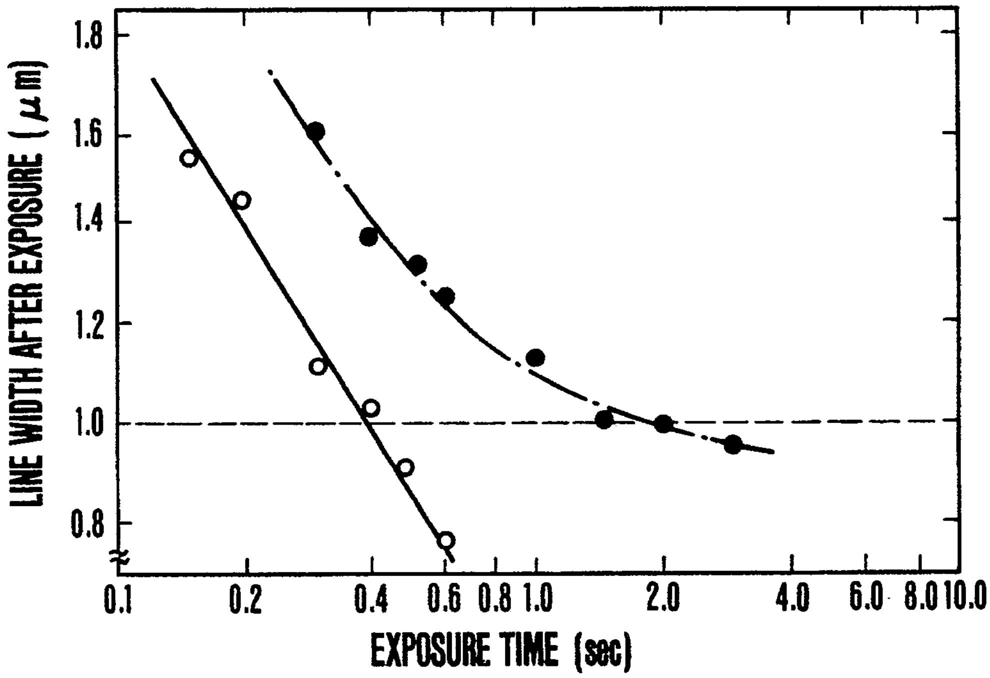

LINE WIDTH AFTER EXPOSURE (μm)
1.8
1.6
1.4
1.2
1.0
0.8
0.1
0.2
0.4
0.6
0.8
1.0
2.0
4.0
6.0
8.0
10.0
EXPOSURE TIME (sec)


# FIG.2

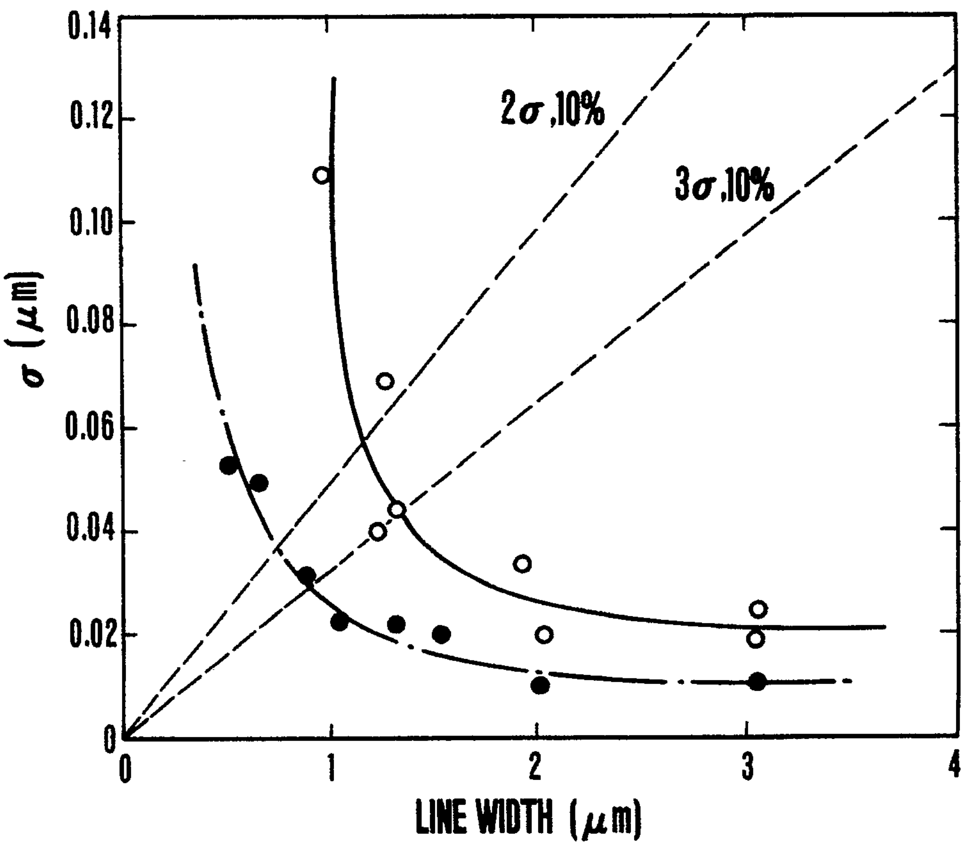

0.14
0.12
0.10
0.08
0.06
0.04
0.02
0
σ (μm)
2σ,10%
3σ,10%
0
1
2
3
4
LINE WIDTH (μm)

FIG. 3

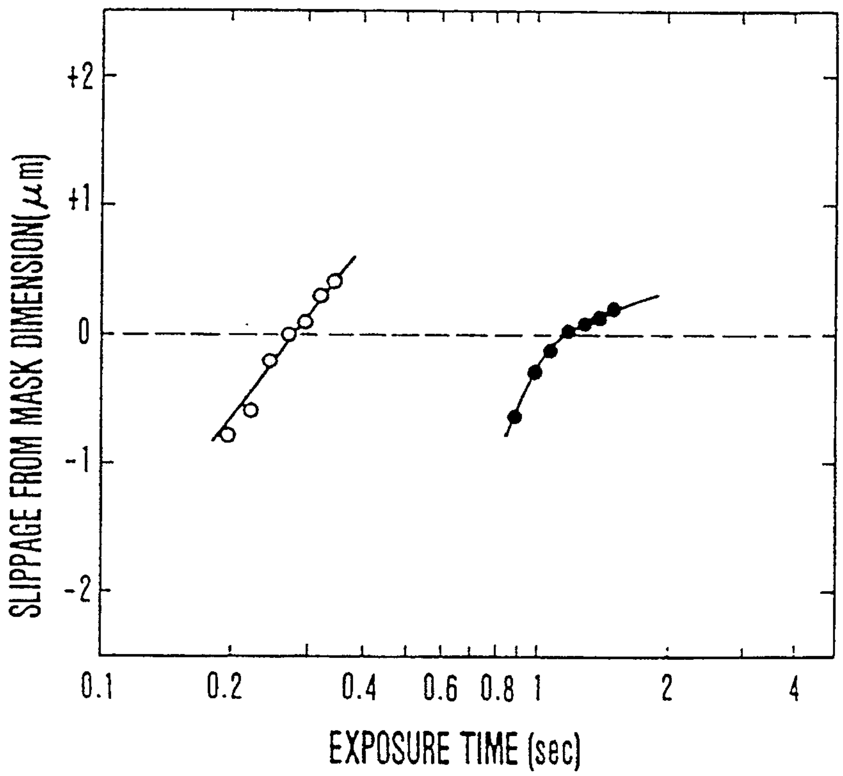
SLIPPAGE FROM MASK DIMENSION(μm)
+2
+1
0
-1
-2
0.1
0.2
0.4
0.6
0.8
1
2
4
EXPOSURE TIME (sec)

FIG. 4

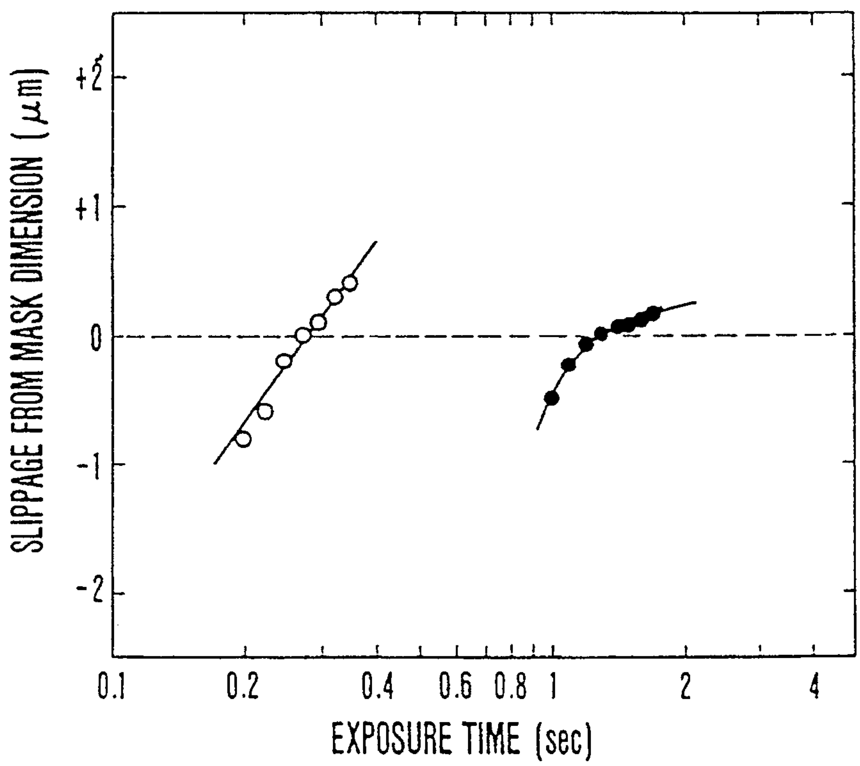
SLIPPAGE FROM MASK DIMENSION (μm)
+2
+1
0
-1
-2
0.1
0.2
0.4
0.6
0.8
1
2
4
EXPOSURE TIME (sec)

# FIG.5

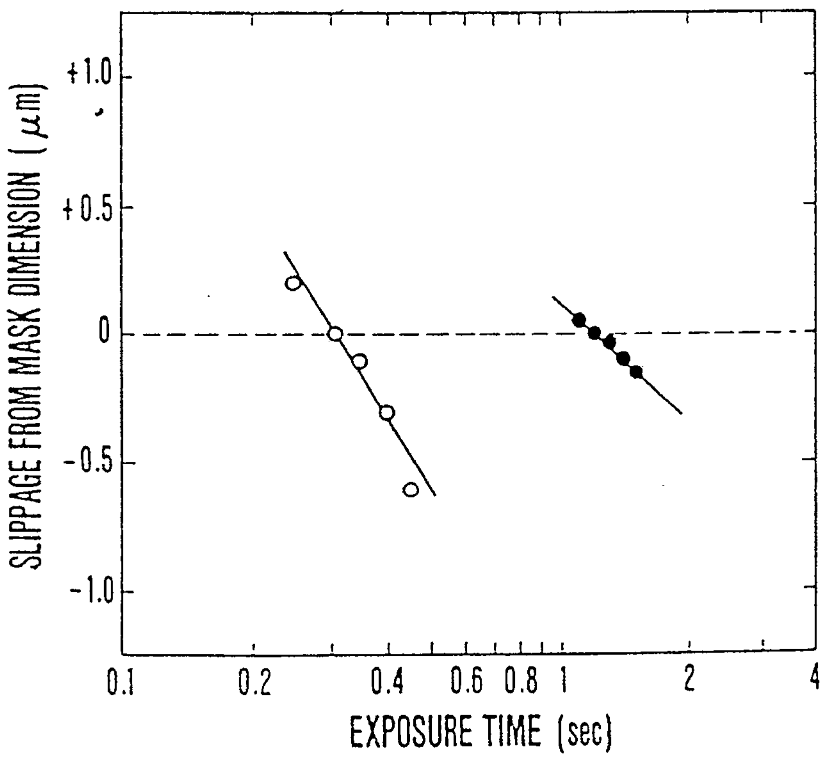
SLIPPAGE FROM MASK DIMENSION (μm)
+1.0
+0.5
0
-0.5
-1.0
0.1
0.2
0.4
0.6
0.8
1
2
4
EXPOSURE TIME (sec)